# EUROPEAN PATENT SPECIFICATION

(11) **EP 0 608 529 B1**
(45) Date of publication and mention of the grant of the patent: **15.11.2000**
(21) Application number: 93119972.3
(22) Date of filing: 10.12.1993
(51) Int. Cl.: H01B 7/08

(54) **Shield flat cable**
Abgeschirmtes Flachkabel
Câble plat blindé

(30) Priority: 26.01.1993 JP 2849693; 04.06.1993 JP 15807193
(43) Date of publication of application: 03.08.1994
(73) Proprietor: SUMITOMO ELECTRIC INDUSTRIES, LTD., Osaka-shi, Osaka 541 (JP)
(72) Inventor: Tanaka, Keiichi, c/o Kantoh Works, Kanuma-shi, Tochigi (JP)
(74) Representative: Grünecker, Kinkeldey, Stockmair & Schwanhäusser Anwaltssozietät

(56) References cited:
- EP-A- 0 452 942
- GB-A- 2 253 936

## Description

The present invention relates to the field of shield flat cables. Especially, the present invention relates to shield flat cables in which conduction to a ground line is made easy and the sliding property thereof is superior.

Conventionally, instead of a stranded wire and a coaxial cable, a flat cable is used for signal transmission in a device such as a communication device or a computer, and in an interface between such devices. However, in the flat cable, there is a problem to make shield of an electromagnetic wave. Although various techniques for solving the problem have been developed, sufficient technique has not been proposed.

A shield flat cable using a gold foil has been known. The structure thereof is such that a metal foil is used, and in order to make the metal foil adhere to a flat cable, an insulative adhesive layer is provided on a surface of the metal foil.

With reference to Figs. 1(a) to 1(d), the structure of a conventional shield cable which is known from JP-A-4-272617 will be described in more detail.

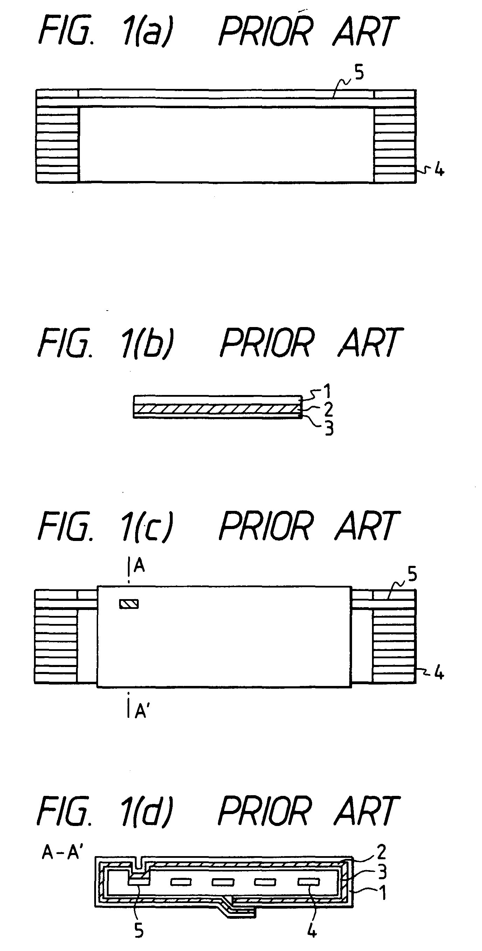

Fig. 1(a) is a schematic view showing a cross section of a conventional flat cable, Fig. 1(b) is a sectional schematic view showing the structure of a conventional typical shield tape including an adhesive 3 coated on an outer substrate 1 through a metal foil 2, Fig. 1(c) is a sectional schematic view showing the structure of the flat cable after the shield tape was wound, and Fig. 1(d) is a schematic view showing a cross section of the shield flat cable.

As described above, conventionally, the metal foil 2 is used as a shield layer, and in order to make conduction after the shield tape was wound (Fig. 1(c)) and adhered through the insulative adhesive, it is necessary to remove the adhesive layer by a specific working such as a spot welding to make conduction as is understood from the cross section shown in Fig. 1(d).

Further shielded cables wherein an electrically conductive layer and an outer protective cover are made by extrusion are known from EP-A-452 942 and from GB-A-2 253 936.

As a result of studies to solve the problem, there is provided a shield flat cable comprising the features of claim 1. The present inventor found that in a flat cable, by making a shield layer of a conductive adhesive layer formed of an adhesive resin containing metal fillers, both adhesion and conduction can be satisfied by merely making the shield layer contact to a ground line and by making simple heating and pressurizing, and the present invention was completed.

That is, according to the present invention,
(1) a shield flat cable having a shield layer formed of an adhesive resin layer containing metal fillers is provided, and
(2) the adhesive resin has adhesiveness to both an insulative coating layer and a conductor of the flat cable.

Further advantageous embodiments are laid down in the subclaims. The present invention will be described below by means of example with reference to the accompanying drawings.
Fig. 1(a) to 1(d) are schematic views each showing a cross section of a conventional shield flat cable,
Figs 2(a) to 2(c) are schematic view each showing a cross section of a shield flat cable of the present invention, and
Fig. 3 is a status view showing the state in which the shield flat cable including a shield tape is bent with a predetermined curvature and is slided.

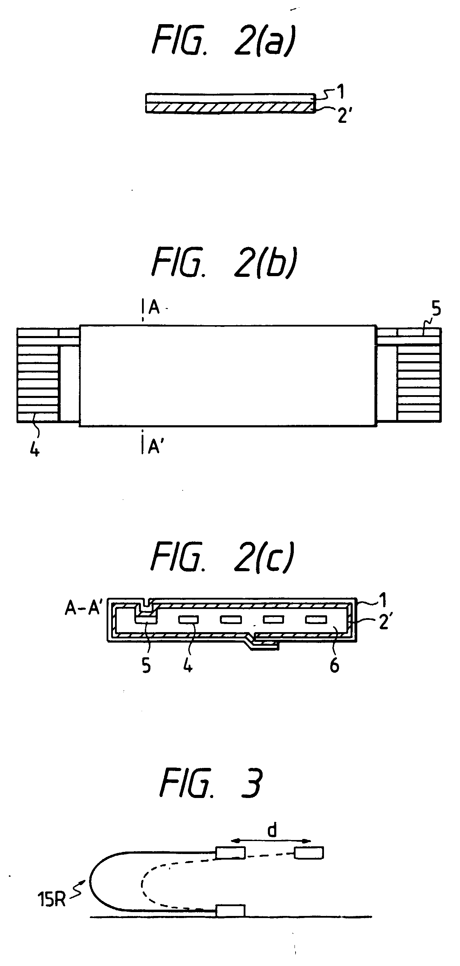

Fig. 2(a) is a schematic view showing the structure of a shield tape for producing a shield flat cable of the pesent invention, Fig. 2(b) is a top view showing the structure of a shield flat cable after the shield tape was wound, and Fig. 2(c) is a sectional view of the shield flat cable.

After a shield substrate 1 coated with an adhesive resin layer 2' (for example, adhesive type or hot melt type) containing metal fillers as shown in Fig. 2(a) is wound on a flat cable with a continuously or partially exposed ground line 5 as shown in Fig. 2(b), the cable is simply heated and pressurized to make the shield layer 2' adhering to an insulative coating layer 6 of the flat cable and contacting to the ground line 5 as shown in Fig. 2(c), thereby obtaining the shield flat cable of the present invention.

As the substrate 1, when a nonflammable engineering plastic film was used, the formed tape electric wire passed a nonflammable test of UL (Underwriter Laboratory) standard.

As the adhesive resin used in the present invention, for example, a hot melt adhesive of polystyrene system, vinyl acetate system, polyethylene system, polypropylene system, polyester system or polyamide system, or an adhesive of rubber system, acryl system, vinyl system such as polyvinyl ether or silicone system is exemplified.

It is desirable that the adhesive resin has adhesiveness to both an insulative coating layer 6 and a conductor 5, of the flat cable. Especially, a polyester system hot melt adhesive is preferable.

As the metal fillers, a metal powder of nickle, copper, silver or the like, an alloy powder of solder or the like, metal whiskers, a glass woven material or carbon palted with a metal is exemplified.

A mixing ratio of the metal fillers to the adhesive resin is not specifically restricted if the electromagnetic wave shield by the shield layer formed of these is effective. Concretely, the ratio is determined in view of the kind, shape, largeness, specific gravity or the like of the metal fillers. The metal fillers are generally 20-300 weight parts for adhesive resion 100 weight parts, and preferably 100-200 weight parts.

As a method of producing the shield layer from the adhesive resin, a method of previously coating a shield substrate with the resin is preferable. As the shield susbtrate, when a nonflammable engineering plastic film of PPS (polyphenyl sulphide), polyamidimido, polyetherimido or polyarylate is used, the formed flat cable passes the nonflammable test of UL.

As the conductor 4, 5, copper or tin-plated copper is generally exemplified.

Fig. 2(c) is a schematic view showing the cross section of a shield flat cable in accordance with the present invention.

A flat cable was constructed such that a plurality of flat tin-plated soft copper foils each having 0.1 mm thickness and 0.8 mm width were arranged with a pitch of 1.25 mm between conductors 4, 5 and were covered with a polyester tape. One side surface of one conductor 5 of the flat cable was continuously made exposed in the longitudinal direction. A shield substrate 1 coated with a polyester system hot melt adhesive containing silver fillers and having a thickness of 12 µm was wound on the polyester tape (corresponding to insulative coating layer 6 in Fig. 2(c)) with a thickness of 9 µm, heated and pressurized so that the shield substrate adhered to the flat cable and conduction to the exposed conductor was easily achieved.

As the shield substrate 1, a PPS film was used. However, a polyamideimido film, polyetherimido film, polyarylate film or the like is also used.

In this example, since the metal filers were contained, as compared with a conventional flat cable using a metal foil, it was found that a thin shield layer (adhesive resin layer) not larger than 20 µm could be formed, and the sliding property of a movable portion was superior as shown in Table 1 even if the shield flat cable was repeatedly bent under the conditions that moving distance d was 25 mm, moving speed was 1000 times/minute and the cable was bent until 15R (radius 15 mm) as shown in Fig. 3.

**[Table 1]**

| | first | second | third I |
|---|---|---|---|
| prior art | 2025 | 2439 | 2705 |
| present invention | 31520 | 29451 | 33550 |
| (note) The values in the table are repeated times until a conductor was broaken. | | | |

As described above, in the shield flat cable of the present invention, conduction between the shield layer and the ground line is easily made.

Further, the shield flat cable of the present invention can be made thin and the sliding property is superior.

When a nonflammable engineering plastic film is used as the shield substrate, the flat cable passes the nonflammable test of UL.

## Claims

1. A shielded flat cable comprising:
a plurality of conductors (4,5),
one insulation layer (6) into which said conductors (4,5) are embedded,
a shield tape wound on said conductors (4,5) and insulation layer (6),
said shield tape comprising
a substrate (1) coated with a shield layer (2'), characterised in that the shield layer is formed of an adhesive resin layer,
wherein said adhesive resin is selected from the group consisting of a polystyrene system hot melt adhesive, a vinyl acetate system hot melt adhesive, a polyethylene system hot melt adhesive, a polypropylene system hot melt adhesive, a rubber system adhesive, an acryl system adhesive, a vinyl system adhesive, and a silicone system adhesive, further wherein said adhesive resin contains metal fillers and additionally wherein said adhesive resin has adhesiveness to both the insulation layer (6) and one of said conductors (4,5).

2. The shielded flat cable of claim 1, wherein said substrate (1) is a non-flammable engineering plastic film.

3. The shielded flat cable of claim 1, wherein said metal fillers are selected from the group consisting of a nickel powder, a copper powder, a silver powder, a solder alloy powder, a metal whisker, a glass woven material plated with a metal, and a carbon plated with metal.

4. The shielded flat cable of claim 1, wherein the ratio of said metal fillers to the said adhesive resin (2') is 20-300 parts by weight of said metal fillers to 100 parts by weight of said adhesive resin (2').

5. The shielded flat cable of claim 1, wherein the thickness of said adhesive resin layer (2') is not greater than 20 µm.

## Patentansprüche

1. Abgeschirmtes Flachkabel mit:
einer Mehrzahl von Leitern (4,5),
einer Isolationsschicht (6), in die die Leiter (4,5) eingebettet sind,
einem Abschirmband, das um die Leiter (4,5) und die Isolationsschicht (6) gewickelt ist,
wobei das Abschirmband aufweist,
ein Substrat (1), beschichtet mit einer Abschirmschicht (2'), **dadurch gekennzeichnet,** daß die Abschirmschicht aus einer Haft-Kunststoffschicht gebildet ist, wobei der Haft-Kunststoff aus der Gruppe ausgewählt ist, die enthält: Heißschmelzkunststoff auf Polystyrenbasis, Heißschmelzkunststoff auf Vinylazetatbasis, Heißschmelzkunststoff auf Polyethylenbasis, Heißschmelzkunststoff auf Polypropylenbasis, Klebstoff auf Gummibasis, Klebstoff auf Akrylbasis, Klebstoff auf Vinylbasis oder Klebstoff auf Silikonbasis, und wobei außerdem der Haft-Kunststoff metallische Füllstoffe enthält und zusätzlich außerdem der Haft-Kunststoff eine Haftfähigkeit sowohl zu der Isolierschicht (6) als auch einem der Leiter (4,5) aufweist.

2. Abgeschirmtes Flachkabel nach Anspruch 1, bei dem das Substrat (1) ein nicht entflammbar ausgeführter Kunststofffilm ist.

3. Abgeschirmtes Flachkabel nach Anspruch 1, bei dem die metallischen Füllstoffe ausgewählt sind aus der Gruppe, die enthält, Nickelpulver, Kupferpulver, Silberpulver, Lotmittellegierungs-Pulver, metallbeschichtetes Glasgewebematerial und metallbeschichteter Kohlenstoff.

4. Abgeschirmtes Flachkabel nach Anspruch 1, bei dem das Verhältnis dieser metallischen Füllstoffe zu dem Haft-Kunststoff (2') 20 bis 300 Gewichtsteile der metallischen Füllstoffe zu 100 Gewichtsteilen des Haft-Kunststoffes (2') besteht.

5. Abgeschirmtes Flachkabel nach Anspruch 1, bei dem die Dicke der Haft-Kunststoffschicht (2') nicht größer als 20 µm ist.

## Revendications

1. Câble plat blindé comprenant :
de nombreux conducteurs (4, 5),
une couche isolante (6) dans laquelle lesdits conducteurs (4, 5) sont encastrés,
une bande de blindage enroulée sur lesdits conducteurs (4, 5) et ladite couche isolante (6),
ladite bande de blindage comprenant
un substrat (1) revêtu d'une couche de blindage (2'), caractérisé en ce que la couche de blindage est constituée d'une couche de résine adhésive,
dans lequel ladite résine adhésive est choisie parmi un adhésif thermofusible de système polystyrène, un adhésif thermofusible de système acétate de vinyle, un adhésif thermofusible de système polyéthylène, un adhésif thermofusible de système polypropylène, un adhésif de système caoutchouc, un adhésif de système acrylique, un adhésif de système vinylique et un adhésif de système silicone, dans lequel ladite résine adhésive contient en outre des charges métalliques et dans lequel ladite résine adhésive présente de plus une adhérence à la fois pour la couche isolante (6) et pour un desdits conducteurs (4, 5).

2. Câble plat blindé selon la revendication 1, dans lequel ledit substrat (1) est un film plastique ininflammable pour la construction.

3. Câble plat blindé selon la revendication 1, dans lequel lesdites charges métalliques sont choisies parmi une poudre de nickel, une poudre de cuivre, une poudre d'argent, une poudre d'alliage pour le brasage, une barbe métallique, un matériau tissé en verre plaqué d'un métal et un carbone plaqué de métal.

4. Câble plat blindé selon la revendication 1, dans lequel le rapport desdites charges métalliques à ladite résine adhésive (2') est de 20-300 parties en poids desdites charges métalliques pour 100 parties en poids de ladite résine adhésive (2').

5. Câble plat blindé selon la revendication 1, dans lequel l'épaisseur de ladite couche de résine adhésive (2') est d'au plus 20 µm.
